(19) Europäisches Patentamt
European Patent Office
Office européen des brevets

(11) **EP 1 495 542 B1**

(12) **EUROPÄISCHE PATENTSCHRIFT**

(45) Veröffentlichungstag und Bekanntmachung des Hinweises auf die Patenterteilung:
**17.10.2007 Patentblatt 2007/42**

(21) Anmeldenummer: **03746221.5**

(22) Anmeldetag: **01.04.2003**

(51) Int Cl.:
**H03K 19/173** [(2006.01)]

(86) Internationale Anmeldenummer:
**PCT/DE2003/001059**

(87) Internationale Veröffentlichungsnummer:
**WO 2003/088488 (23.10.2003 Gazette 2003/43)**

(54) **SCHALTUNGSANORDNUNG UND VERFAHREN ZUR ERZEUGUNG EINES DUAL-RAIL-SIGNALS**

CIRCUIT ARRANGEMENT AND METHOD FOR GENERATING A DUAL-RAIL OUTPUT SIGNAL

CIRCUIT ET PROCEDE POUR PRODUIRE UN SIGNAL DE SORTIE DOUBLE VOIE

(84) Benannte Vertragsstaaten:
**DE FR**

(30) Priorität: **18.04.2002 DE 10217375**

(43) Veröffentlichungstag der Anmeldung:
**12.01.2005 Patentblatt 2005/02**

(73) Patentinhaber: **Infineon Technologies AG**
**81669 München (DE)**

(72) Erfinder:
• **KÜNEMUND, Thomas**
**80337 München (DE)**
• **SEDLAK, Holger**
**82054 Sauerlach (DE)**

(74) Vertreter: **Epping - Hermann - Fischer**
**Ridlerstrasse 55**
**80339 München (DE)**

(56) Entgegenhaltungen:
**EP-A- 0 334 050         EP-A- 0 440 514**
**US-A- 4 570 084**

• **KAZUO YANO ET AL: "A 3.8-NS CMOS 16 X 16-B MULTIPLIER USING COMPLEMENTARY PASS-TRANSISTOR LOGIC" IEEE JOURNAL OF SOLID-STATE CIRCUITS, IEEE INC. NEW YORK, US, Bd. 25, Nr. 2, 1. April 1990 (1990-04-01), Seiten 388-395, XP000116678 ISSN: 0018-9200**

• **PATENT ABSTRACTS OF JAPAN vol. 011, no. 117 (E-498), 11. April 1987 (1987-04-11) -& JP 61 264820 A (FUJITSU LTD), 22. November 1986 (1986-11-22)**

• **HONG-YI HUANG ET AL: "New CMOS differential logic circuits for true-single-phase pipelined systems" CIRCUITS AND SYSTEMS, 1994. ISCAS '94., 1994 IEEE INTERNATIONAL SYMPOSIUM ON LONDON, UK 30 MAY-2 JUNE 1994, NEW YORK, NY, USA,IEEE, US, 30. Mai 1994 (1994-05-30), Seiten 15-18, XP010143200 ISBN: 0-7803-1915-X**

• **LAI F-S ET AL: "DESIGN AND IMPLEMENTATION OF DIFFERENTIAL CASCODE VOLTAGE SWITCH WITH PASS-GATE (DCVSPG) LOGIC FOR HIGH-PERFORMANCE DIGITAL SYSTEMS" IEEE JOURNAL OF SOLID-STATE CIRCUITS, IEEE INC. NEW YORK, US, Bd. 32, Nr. 4, 1. April 1997 (1997-04-01), Seiten 563-573, XP000659736 ISSN: 0018-9200**

• **CHUN-KEUNG LO ET AL: "Design of low power differential logic using adiabatic switching technique" CIRCUITS AND SYSTEMS, 1998. ISCAS '98. PROCEEDINGS OF THE 1998 IEEE INTERNATIONAL SYMPOSIUM ON MONTEREY, CA, USA 31 MAY-3 JUNE 1998, NEW YORK, NY, USA,IEEE, US, 31. Mai 1998 (1998-05-31), Seiten 33-36, XP010289175 ISBN: 0-7803-4455-3**

• **"ASYMMETRIC TRANSITION DUAL-RAIL SIGNALLING" IBM TECHNICAL DISCLOSURE BULLETIN, IBM CORP. NEW YORK, US, Bd. 37, Nr. 1, Januar 1994 (1994-01), Seiten 69-84, XP001162830 ISSN: 0018-8689**

**Beschreibung**

Üblicherweise sind Schaltnetze mikroelektronisch so ausgeführt, daß jedes Bit der zu verarbeitenden Information physikalisch durch genau einen elektrischen Knoten dargestellt wird. Ein solcher Aufbau wird auch "Single-Rail"-Schaltungstechnik genannt. Solche Schaltnetze sind jedoch verhältnismäßig unsicher gegenüber der sogenannten differentiellen Stromprofilanalyse, die beim Versuch des Zugriff unberechtigter Dritter auf geheime Informationen angewandt wird. Die differentielle Stromprofilanalyse, englisch als Differential Power Analysis -DPA- bezeichnet, ist eine der wichtigsten Methoden zum Angriff auf beispielsweise Chipkarten für Sicherheitsanwendungen. Dabei erfolgt ein gezielter Angriff auf vertrauliche Informationen wie Paßwörter oder kryptografische Schlüssel. Für ein gegebenes Programm beziehungsweise einen gegebenen Algorithmus werden mit statistischen Methoden gemessene Stromprofile der Chipkarte beziehungsweise deren über ein oder mehrere Takte berechnete Ladungsintegrale ausgewertet, wobei - für eine Vielzahl von Programmausführungen - aus der Korrelation von systematischer Datenvariation und jeweiligem Ladungsintegral Rückschlüsse auf die zu schützenden Information gezogen werden können.

Im Gegensatz zur herkömmlichen Single-Rail-Schaltungstechnik, bei der jedes Bit innerhalb eines Daten- oder Signalpfades physikalisch durch genau einen elektrischen Knoten k dargestellt wird, wird bei der Implementierung mit Dual-Rail-Schaltungstechnik jedes Bit durch zwei Knoten k und kq dargestellt, wobei dieses Bit einen gültigen logischen Wert aufweist, wenn k dem wahren logischen Wert b dieses Bits entspricht und kq dem negierten Wert bn = not(b).

Wenn also der Wert b = 1 übertragen werden soll, so geschieht dies durch eine "1" im Knoten k. Gleichzeitig wird jedoch der Wert "0" am Knoten kq übertragen, so daß insgesamt also sowohl eine "1" als auch eine "0" übertragen wird. Wenn der Wert b = 0 zu übertragen ist, erfolgt gleichzeitig eine Übertragung des Wertes "1" am Knoten kq. In beiden Fällen wird also eine "1" und eine "0" übertragen. Physikalische Gleichheit des Knoten k und kq vorausgesetzt, ist nun mittels einer differentiellen Stromprofilanalyse nicht mehr erkennbar, ob als Datum eine "1" oder eine "0" übertragen wird. Dies gilt jedoch nur dann, wenn tatsächlich bei jedem übertragenen Datum ein Signalwechsel stattfindet, sich also die Information "1" und die Information "0" abwechseln. Werden mehrere gleiche Daten nacheinander übertragen, verschlechtern sich die Eigenschaften bezüglich der Angreifbarkeit durch differentielle Stromprofilanalyse.

Die gewünschte Invarianz der Ladungsintegrale wird nun dadurch erreicht, daß zwischen je zwei Zuständen mit gültigen logischen Werten (b, bn) = (1,0) oder (0,1) ein sogenannter Vorladezustand, im englischen auch Precharge genannt, eingefügt ist, für den sowohl k als auch kq auf dasselbe elektrische Potential geladen werden, also logisch ungültige Werte (1,1) oder (0, 0) annehmen. Für den Vorlade-Zustand (1,1) könnte also eine Zustandsfolge aussehen wie folgt:

$$(1, 1) \rightarrow (0, 1) \rightarrow (1, 1) \rightarrow (1, 0) \rightarrow (1,1) \rightarrow (1, 0) \rightarrow (1, 1) \rightarrow (0, 1) \rightarrow ...$$

Für jede beliebige solcher Zeichenfolgen gilt, daß für jeden Übergang $(1,1) \rightarrow (b, bn)$ genau ein Knoten von "1" nach "0" umgeladen wird, und für alle $(b, bn) \rightarrow (1,1)$ genau ein Knoten von "0" nach "1", unabhängig vom logischen gültigen Wert b des in Frage stehenden Zustandsbits. Analoges gilt für Zustandsfolgen mit dem Vorlade-Zustand (0,0).

Daraus folgt, daß die diesen Zustandsfolgen entsprechenden Ladungsintegrale unabhängig sind von der Abfolge (b, bn) der logisch gültigen Werte, falls dafür Sorge getragen wird, daß die Knoten k und kq gleiche elektrische Kapazitäten aufweisen. Das Stromprofil eines so implementierten Datenpfades hängt also nicht ab von zeitlichen Variationen der zu verarbeitenden Daten und ist somit resistent gegen differentielle Stromprofilanalyse.

Eine Schaltungsanordnung gemäß Oberbegriff des Anspruchs 1 ist aus dem Dokument US-A-4 570 084 bekannt.

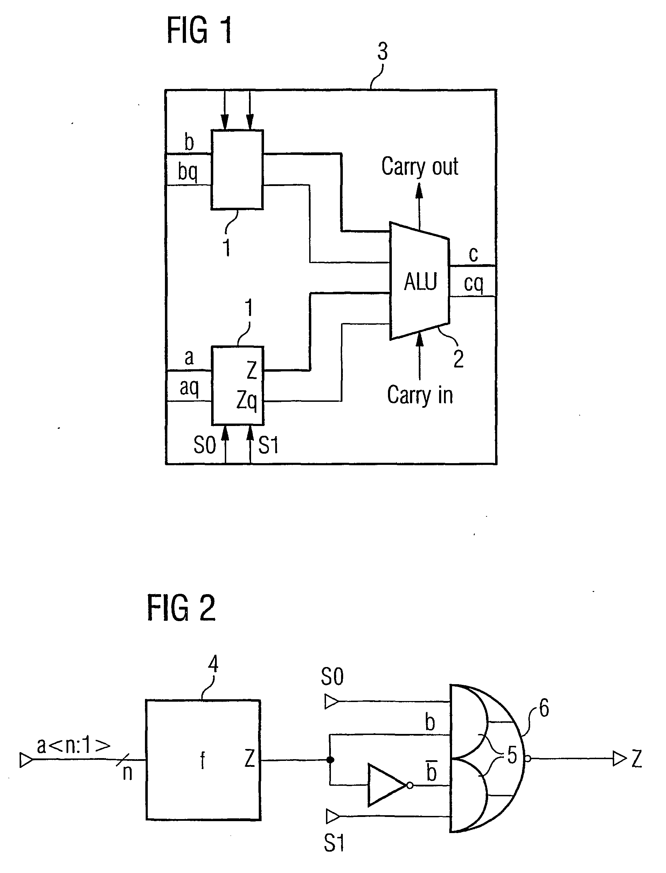

Schaltungsanordnungen zum Erzeugen eines Dual-Rail-Signales werden beispielsweise in einer Datenverarbeitungsvorrichtung eingesetzt, wie sie in Figur 1 gezeigt ist. Dort ist eine Datenverarbeitungsvorrichtung 3 gezeigt, die ein Rechenwerk 2, oft als Arithmetic Logical Unit (ALU) bezeichnet, besitzt. Eine solche ALU ist dafür vorgesehen, zwei Eingangswerte miteinander zu verknüpfen, indem sie beispielsweise eine Addition durchführt. Zwei Eingangswerte a und b werden also zu einem Ausgangswert c verknüpft. Eine Subtraktion kann dadurch ausgeführt werden, daß einer der beiden zu verknüpfenden Werte invertiert der ALU zugeführt wird und gleichzeitig ein Carry-bit des Carry-in-Eingangs der ALU gesetzt wird. Statt des Signales a wird im Beispiel von Figur 1 das Signal not(a) benötigt. Dazu besitzt die Datenverarbeitungsvorrichtung 3 vorverarbeitende Eingangsschaltungen 1, die dazu geeignet sind, die Funktion not(a) bereitzustellen.

Die Eingangsschaltung 1 liefert ein Ausgangssignal Z, das der ALU übergeben wird. In anderen Fällen wird als Eingangswert für die ALU der Wert "0" oder der Wert "1" benötigt, die Eingangsschaltung 1 muß also auch in der Lage sein, diese beiden Werte bereitzustellen. Die erforderlichen Ausgangsfunktionen z der Eingangsschaltung 1 sind also:

z = f(a),
z = not(f(a)),
z = 0 und
z = 1

Die Funktion f gibt dabei an, daß eine weitere Verarbeitung der Eingangsdaten a erfolgen kann, beispielsweise wenn die Daten a verschlüsselt sind und zunächst entschlüsselt werden sollen, damit eine Weiterverarbeitung in der ALU möglich ist. Welche dieser vier Funktionen umgesetzt werden soll, wird durch Steuersignale S0, S1 bestimmt, die der Eingangsschaltung 1 zugeführt werden.

Neben den in Figur 1 fett gezeichneten Signalwegen für die Signale a, b, z und c sind feiner gezeichnet Signalwege für Signale aq, bq, zq und cq gezeichnet. Diese Signalwege beziehungsweise diese Signale sind vorhanden, wenn es sich um eine Datenverarbeitungsvorrichtung 3 handelt, die für die Verarbeitung von Dual-Rail-Signalen geeignet ist. Neben dem eigentlichen Datensignal ist immer noch das komplementäre Signal vorhanden, sofern es sich um ein gültiges Datum handelt. In dem oben genannten Vorlade-Zustand wird auf beiden Signalleitungen das gleiche Signal geführt, es gilt also a = aq, b = bq, z = zq und c = cq.

Die durch die Eingangsschaltung 1 zu realisierende Funktion in Verbindung mit den beiden Steuerbits S0 und S1 lautet also

$$z = \text{not } (s1 \cdot \text{not}(f(a<n:1>) + s0 \cdot f(a<n:1>)).$$

Gemäß dem Stand der Technik wird eine solche Funktion durch eine Schaltungsanordnung realisiert, wie sie in Figur 2 dargestellt ist. Ein n Bit breites Datenwort a<n:1> wird einer ersten Schaltungseinheit 4 zugeführt. Diese bildet die Funktion f(a). Dieses Signal wird zusätzlich invertiert, so daß zur Weiterverarbeitung sowohl f(a) als auch not(f(a)) zur Verfügung stehen. f(a) wird sodann mit dem Steuerbit S0 in einer AND-Schaltung verknüpft. Ebenso ist der Wert not(f(a)) in einer AND-Schaltung mit dem Steuerbit S1 verknüpft. In einer OR-Schaltung werden die Ausgangswerte der beiden AND-Glieder zu dem Ausgangswert z verknüpft.

Es kommen also mehrere in Serie geschaltete herkömmliche Gatter zur Anwendung. Eine solche, der logischen Systematik folgende Schaltungsanordnung ist verhältnismäßig aufwendig bezüglich der Anzahl der zu verwendenden Transistoren, insbesondere wenn statt eines Single-Rail-Signals ein Dual-Rail-Signal verwendet werden soll. Darüber hinaus ist die Verarbeitungszeit in solchen Schaltungsanordnungen, die zudem einen hohen Stromverbrauch aufweisen, verhältnismäßig lang.

Wie aus dem in Figur 1 gezeigten Anwendungsfall hervorgeht, tritt eine solche Schaltung nicht nur einfach in einer Datenverarbeitungsvorrichtung auf, sondern muß für jedes parallel zu verarbeitende Bit separat ausgeführt werden. Bei einem Prozessor, der mit einer Busbreite von 32 Bit arbeitet, ist die Schaltung also 2 · 32 = 64 mal auszuführen.

Aufgabe der Erfindung ist es daher, eine Schaltungsanordnung zur Erzeugung eines Dual-Rail-Ausgangssignals anzugeben, die einfacher im Aufbau ist und sich mit weniger Transistoren realisieren läßt. Außerdem soll ein entsprechendes Verfahrens angegeben werden.

Diese Aufgabe wird durch eine Schaltungsanordnung zur Erzeugung eines Dual-Rail-Ausgangssignals gelöst mit einem ersten Eingang mit mindestens zwei Anschlüssen zum Empfang eines Dual-Rail-Eingangssignals, einem zweiten Eingang zum Empfang eines Steuersignals, einer Signalverarbeitungsvorrichtung mit einem ersten und einem zweiten jeweils in Anhängigkeit von dem Eingangssignal ansteuerbaren Schaltern sowie zwei Ausgängen, wobei durch einen der Schalter der erste Ausgang und durch den anderen Schalter der zweite Ausgang mit einem sich auf einem ersten Potential befindlichen Fußpunkt der Steuervorrichtung verbindbar sind, einer Schaltvorrichtung, aufweisend zwei Eingänge, die mit den Ausgängen der Signalverarbeitungsvorrichtung verbunden sind, und zwei Ausgängen, die mit zwei Ausgängen der Schaltungsanordnung zur Ausgabe eines Dual-Rail-Ausgangssignals verbunden sind, wobei die Ausgänge in Abhängigkeit von einem Steuersignal jeweils mit einem oder beiden Eingängen verbindbar sind, und einer Potentialkontrollvorrichtung zur Festlegung der Potentiale der Ausgänge der Schaltungsanordnung, wenn diese nicht über die Schaltvorrichtung und die Signalverarbeitungsvorrichtung mit dem Fußpunkt der Signalverarbeitungsvorrichtung verbunden sind. Die erfindungsgemäße Schaltungsanordnung ermöglicht die folgenden Betriebssituationen wobei E1 und E2 die Ausgänge und D1 und D2 die Eingänge der Schaltvorrichtung sind:

E1 verbunden mit D1 und E2 verbunden mit D2: z = not(f(a)),
E1 verbunden mit D2 und E2 verbunden mit D1: z = f(a),
E1 verbunden mit D1 und D2, E2 offen: z = 0,
E2 verbunden mit D1 und D2, E1 offen: z = 1.

Zudem wird die Aufgabe durch ein Verfahren gemäß Patentanspruch 5 gelöst.

Der Vorteil der erfindungsgemäßen Schaltungsanordnung besteht darin, daß der Ausgang nicht nur die Werte f(a) und fq = not (f(a)) annehmen kann, sondern auch die beiden Werte "0" und "1" annehmen kann. Dabei ist die Schaltung sehr einfach aufgebaut und besitzt nicht viele Transistoren. Neben den Transistoren, die in der Signalverarbeitungsvorrichtung für die Ausführung der Funktionen f(a, aq) und fq(a, aq) zuständig sind, sind lediglich vier Transistoren für die Schaltvorrichtung sowie Transistoren für die Potentialkontrollvorrichtung vonnöten. In einer bevorzugten Ausgestaltung kommt die Potentialkontrollvorrichtung mit nur zwei Transistoren aus.

Besonders vorteilhaft ist, daß fast die gesamte Schaltung mit nur einem Transistortyp realisiert werden kann. Dies wirkt sich positiv auf den Stromverbrauch der Schaltung aus, da für Umladevorgänge in diesem Fall weniger Strom verbraucht wird.

Weiterhin ist vorteilhaft, wenn eine zusätzliche Vorlade-Vorrichtung vorgesehen ist, durch die vor jedem übertragenen Datum ein vorbestimmtes gleiches Potential an allen Daten führenden Anschlüssen des Ausgangs erzeugbar ist. Somit ist eine besondere Sicherheit gegen differentielle Stromprofilanalyse gegeben.

In einer günstigen Ausführung der Signalverarbeitungsvorrichtung beinhaltet diese eine XOR-Funktion.

Die Erfindung wird nachfolgend anhand eines Ausführungsbeispieles näher erläutert. Es zeigt:

Figur 1    eine Datenverarbeitungsvorrichtung, in der eine erfindungsgemäße Schaltungsanordnung einsetzbar ist,

Figur 2    eine Schaltungsanordnung nach dem Stand der Technik,

Figur 3    eine erfindungsgemäße Schaltungsanordnung in einer schematischen Darstellung,

Figur 4    eine konkrete Realisierung der Schaltungsanordnung von Figur 2,

Figur 5    ein Zeitdiagramm mit den Signalen der Schaltungsanordnung von Figur 4,

Figur 6    ein erstes Ausführungsbeispiel einer Signalverarbeitungsvorrichtung,

Figur 7    ein zweites Ausführungsbeispiel einer Signalverarbeitungsvorrichtung und

Figur 8    eine Ausführung einer erfindungsgemäßen Schaltungsanordnung gemäß Figur 3 mit p-Kanal-Transistoren.

Figur 1 zeigt die bereits einleitend beschriebene Datenverarbeitungsvorrichtung, in der eine erfindungsgemäße Schaltungsanordnung einsetzbar ist.

Figur 2 zeigt eine Schaltungsanordnung nach dem Stand der Technik, die ebenfalls bereits einleitend beschrieben wurde.

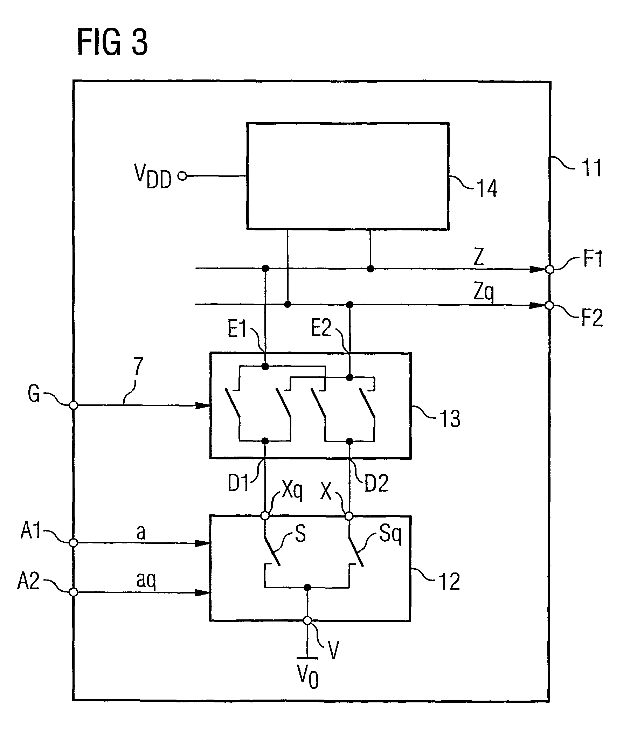

Figur 3 zeigt eine erfindungsgemäße Schaltungsanordnung in einer schematischen Darstellung. Die Schaltungsanordnung 11 besitzt einen Eingang A1 und A2, an dem ein Dual-Rail-Signal eingespeist wird. Der Eingang A1 empfängt dabei das Datensignal a und der Eingang A2 das komplementäre Datensignal aq. Beide Signale werden der Signalverarbeitungsvorrichtung 12 zugeführt. Die Signalverarbeitungsvorrichtung 12 steht für die schaltungstechnische Realisierung von zwei boolschen Schalterfunktionen, wobei $\hat{f}$ die sogenannte "Dual-Rail"-Darstellung von f ist:

$$s = \hat{f}\ (a\langle n{:}1\rangle,\ aq\langle n{:}1\rangle)$$

und

$$sq = \hat{f}q(a\langle n{:}1\rangle,\ aq\langle n{:}1\rangle),$$

wobei gilt:

$$\hat{f}(a,aq) = f(a) \quad \text{falls } aq\langle j\rangle = \text{not}(a\langle j\rangle)\,\forall\,j$$

sowie

$$sq = \text{not}(s) \qquad \text{falls } aq\langle j\rangle = \text{not}(a\langle j\rangle) \; \forall j.$$

Dabei bedeutet s = 0 beziehungsweise sq = 0, daß der jeweilige Schalter geöffnet ist und keine leitende Verbindung zwischen einem Fußpunkt v der Signalverarbeitungsvorrichtung 12 und Ausgängen x und xq der Signalverarbeitungsvorrichtung 12 besteht. Dagegen bedeutet s = 1 beziehungsweise sq = 1, daß der Fußpunkt v mit den Ausgängen x beziehungsweise xq leitend verbunden ist.

Die Ausgänge x und xq der Signalverarbeitungsvorrichtung 12 sind mit Eingängen D1 und D2 einer Schaltvorrichtung 13 verbunden. Ausgänge E1 und E2 sind mit Ausgängen F1 und F2 der gesamten Schaltungsanordnung verbunden, so daß dort ein Ausgangssignal z und zq bereitgestellt wird, wobei dies ein Dual-Rail-Signal ist. Bei gültigen Daten ist also zq das zu z komplementäre Signal.

Weiterhin ist ein Steuereingang G vorgesehen, an dem ein Steuersignal 7 eingespeist und an die Schaltvorrichtung 13 weitergeleitet werden kann. Das Steuersignal 7 bestimmt, wie die Eingänge D1 und D2 mit den Ausgängen E1 und E2 der Schaltvorrichtung 13 verbunden werden.

Zur Erklärung der Funktionsweise wird zunächst angenommen, daß durch eine Potentialkontrollvorrichtung 14 sich die beiden Ausgänge F1 und F2 auf dem zweiten Potential VDD befinden. Durch Schließen entsprechender Schalter in der Signalverarbeitungsvorrichtung 12 und der Schaltvorrichtung 13 ist jeder der Ausgänge F1 und F2 mit dem Fußpunkt v der Signalverarbietungsvorrichtung verbindbar, der sich in der Darstellung von Figur 3 auf dem ersten Potential V0 befindet.

Es wird nun davon ausgegangen, daß ein gültiges Datensignal a, aq anliegt. Dies bewirkt, daß entweder die Verbindung zwischen x und v oder zwischen xq und v geschlossen wird, während die andere Verbindung geöffnet ist. Dies folgt daraus, daß die Dual-Rail-Signale a und aq bei gültigen Daten komplementär sind, wie oben beschrieben. Dies gilt auch für die Schalterfunktionen s und sq. Durch das Steuersignal 7 kann nun erreicht werden, daß die Eingänge D1 und D2 und die Ausgänge E1 und E2 der Schaltvorrichtung 13 beliebig miteinander verschaltet werden können. Wenn zunächst angenommen wird, daß durch den Schalter s der Fußpunkt v der Signalverarbeitungsvorrichtung 12 mit xq verbunden ist und darüber hinaus D1 mit E1 verbunden ist, so wird F1 auf das erste Potential V0 gezogen, da der Ausgang F1 leitend mit V verbunden ist. Das Ausgangssignal z ist demnach "0".

Daraus folgt entsprechend der Logik der Dual-Rail-Systematik, daß der andere Ausgang auf dem komplementären Spannungspegel, nämlich auf VDD liegen muß. Entsprechend verbindet die Potentialkontrollvorrichtung 14 im soeben beschriebenen Beispiel den Ausgang F2 mit dem zweiten Potential VDD.

Wenn zusätzlich D2 mit E2 verbunden ist, so hängt das Signal z, zq nur noch von der Schalterstellung der Signalverarbeitungsvorrichtung 12 ab. Somit ist die Funktion z = not(f(a)) realisiert.

Soll die Funktion z = f(a) realisiert werden, so kann dies dadurch geschehen, daß D1 mit E2 und D2 mit E1 verbunden wird.

Die dritte zu realisierende Funktion lautet z = 0. Dies wird dadurch realisiert, daß E1 sowohl mit D1 als auch mit D2 verbunden wird, während die Verbindung zu E2 offen bleibt. Einer der Ausgänge x oder xq der Signalverarbeitungsvorrichtung 12 ist immer mit dem Fußpunkt v verbunden. Durch die Verbindung von E1 sowohl mit D1 als auch mit D2 ist somit der Ausgang E1 der Schaltvorrichtung 13 unabhängig von den anliegenden Daten a, aq und der daraus sich ergebenden Schalterstellungen s, sq immer mit dem ersten Potential 0 verbunden, entweder über den Schalter s oder den Schalter sq der Signalverarbeitungsvorrichtung 12.

Die Funktion z = 1 ist dadurch realisierbar, daß der Ausgang E1 der Schaltvorrichtung 13 offen bleibt. Ohne zusätzliche Ansteuerung bleibt das Potential beim Ausgang F1 auf dem zweiten Potential VDD. Um ein gültiges Dual-Rail-Signal zu erzeugen, muß nun noch der Ausgang F2 zur Ausgabe des Signals zq auf das erste Potential 0 gezogen werden. Dazu wird der Ausgang E2 sowohl mit dem Eingang D1 als auch mit dem Eingang D2 der Schaltvorrichtung 13 verbunden. In der beschriebenen Weise ist somit sichergestellt, daß der Ausgang F2 mit dem Fußpunkt v unabhängig von den anliegenden Daten a, aq verbunden ist.

In einer einfachen Ausführung der Potentialkontrollvorrichtung besteht diese aus zwei Pull-Up-Widerständen, durch die die Ausgänge F1 und F2 mit dem zweiten Potential VDD verbunden sind. Der Nachteil einer solchen Lösung besteht darin, daß bei einer Verbindung eines Ausgangs mit dem ersten Potential V0 durch den Widerstand ein Querstrom fließt, der zu einem unerwünschten Stromverbrauch führt. Dieser unerwünschte Querstrom tritt auch dann auf, wenn ein als Widerstand geschalteter Transistor verwendet wird.

In einer vorteilhafteren Ausführung sind daher zwei Transistoren vorgesehen, wobei jeweils ein Transistor einen Ausgang mit dem zweiten Potential VDD über seine Drain-Source-Strecke verbindet. Der Gateanschluß ist jeweils von dem anderen Ausgang angesteuert. Wenn es sich also um p-Kanal-Transistoren handelt, wird der Transistor automatisch durchgesteuert, sobald das Potential an dem Ausgang, der mit dem Gate verbunden ist, 0 wird. Auf diese Weise ist das Auftreten von Querströmen verhindert.

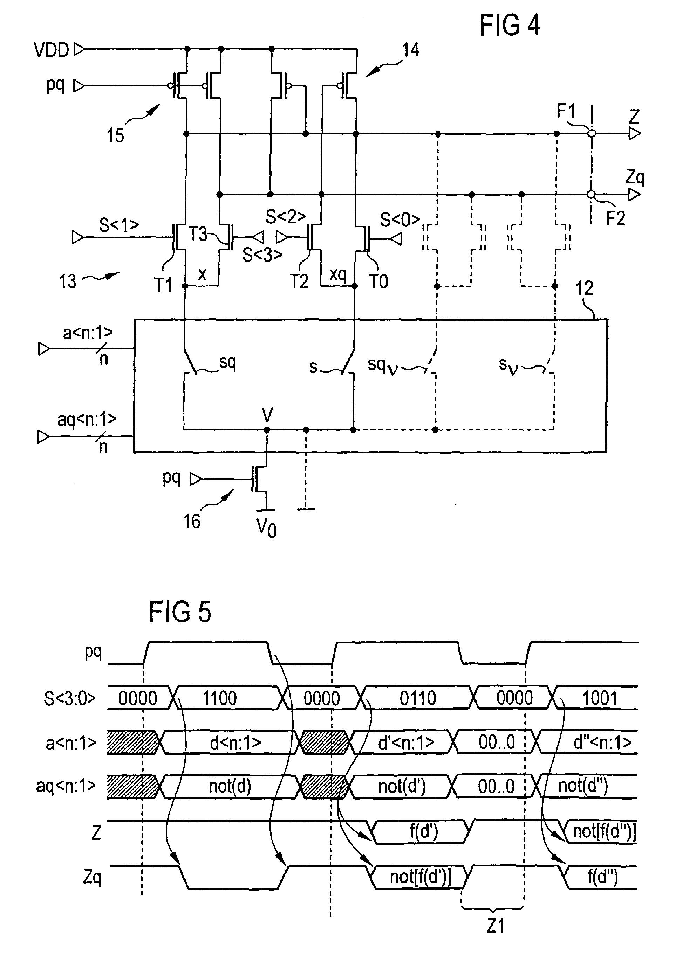

In der Figur 4 ist ein detaillierteres Ausführungsbeispiel einer erfindungsgemäßen Schaltungsanordnung dargestellt. Das Steuersugnal 7 wird durch die vier einzelnen Signalen s<3>, s<2>, s<1> und s<0> gebildet. Zusätzlich zu der bereits beschriebenen Anordnung der Transistoren der Potentialkontrollvorrichtung 14 sind zwei Precharge-Transistoren 15 gezeigt. Diese verbinden das zweite Potential VDD mit den beiden Ausgängen F1 und F2. Die Transistoren 15 werden durch ein gemeinsames Precharge-Signal pq angesteuert. Wenn pq = 0 ist, schalten die Transistoren durch und die beiden Ausgänge F1 und F2 sind mit dem zweiten Potential VDD verbunden.

Dies kann jedoch zu Problemen führen, wenn gleichzeitig die Schaltvorrichtung 13 durchschaltet und die Signalverarbeitungsvorrichtung 12 eine Verbindung zum Fußpunkt v herstellt und dieser direkt mit dem ersten Potential 0 verbunden ist. In diesem Fall besteht zwischen VDD und dem Potential 0 ein Kurzschluß. Um dies zu verhindern gibt es zwei Möglichkeiten. Eine Möglichkeit besteht darin, den Fußpunkt v über einen zusätzlichen Transistor 16 mit dem Potential 0 zu verbinden, wobei dieser Transistor 16 ebenfalls durch das Precharge-Signal pq angesteuert ist. Gleichzeitig mit dem Schließen der Precharge-Transistoren 15 öffnet der Fußpunkttransistor 16, so daß der Strompfad zwischen VDD und dem ersten Potential V0 unterbrochen ist, selbst wenn die Schaltvorrichtung 13 und die Signalverarbeitungsvorrichtung 12 durchgeschaltet sind. Die andere Möglichkeit besteht darin, das Steuersignal 7 und das Precharge-Signal so aufeinander abzustimmen, daß sichergestellt ist, daß bei geschlossenen Precharge-Transistoren 15 die Schalttransistoren der Schaltvorrichtung 13 geöffnet sind.

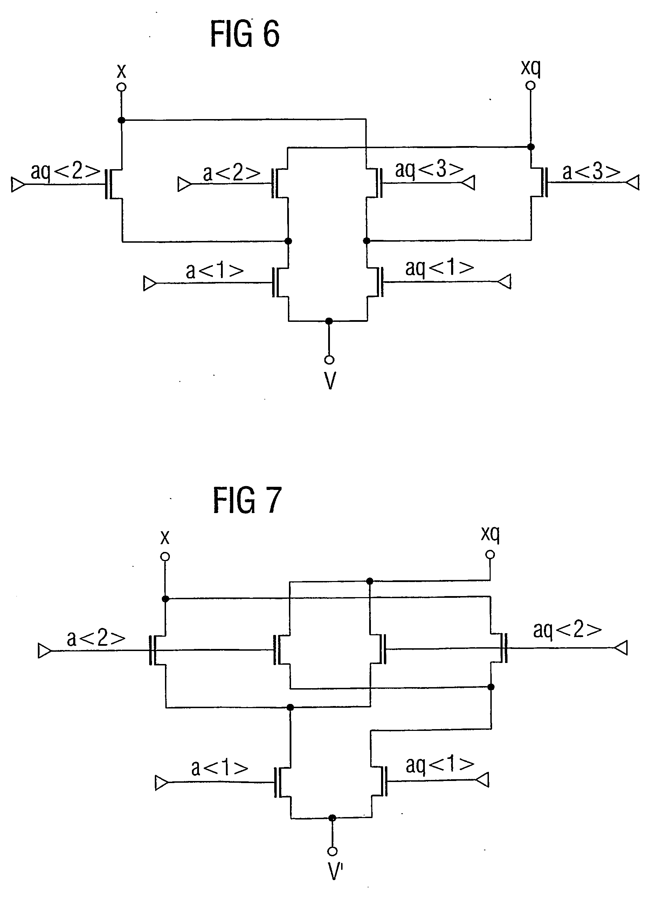

Darüber hinaus besteht natürlich die Möglichkeit, daß die anliegenden Daten a, aq so zugeführt werden, daß gilt s = sq = 0, wenn einer der Schalter der Schaltvorrichtung 13 geschlossen ist und gleichzeitig pq = 0 ist. Zum besseren Verständnis ist in Figur 5 ein Signaldiagramm dargestellt, aus dem die zeitliche Abfolge der auftretenden Signale in der Schaltung von Figur 4 entnehmbar sind. Gezeigt ist dort beispielsweise die Zeitspanne Z1. Zum Beginn von Z1 wird pq = 0, so daß die Precharge-Transistoren 15 in Figur 4 niederohmig werden. Gleichzeitig sind jedoch die Transistoren T1 und T2 entsprechend dem Steuersignal s<3:0> = (0110) ebenfalls niederohmig. Ein Kurzschluß zwischen VDD und V0 ist jedoch dadurch verhindert, daß a = aq = 0 und damit s = sq = 0 ist, solange bis pq wieder 1 wird und die Precharge-Transistoren hochohmig werden. Zwei geeignete Schaltungen sind in den Figuren 6 und 7 beispielhaft dargestellt und werden unten näher beschrieben.

Weiterhin zeigt Figur 5 die übrigen Signalabläufe, die bereits anhand der Schaltungen von Figur 3 und 4 beschrieben worden sind, so daß die Darstellung auch zum Verständnis dieser Schaltungen herangezogen werden kann.

Die Schaltvorrichtung 13 in Figur 3 und 4 realisiert das gewünschte Ausgangsverhalten mit vier Steuerbits. Zwar sind nur vier verschiedene Betriebszustände auszuwählen, da jedoch vier Transistoren vorgesehen sind, ist es vorteilhaft, auf vier Steuerbits zurückzugreifen. Alternativ könnte die Ansteuerung mit zwei Steuerbits erfolgen, die durch eine zusätzliche Schaltung zur Ansteuerung der vier Transistoren aufgespalten werden müßten. Es ergibt sich die folgende Zuordnung:

| pq | S<3:0> | z | zq |
|----|--------|------|--------|
| 1 | 0011 | 0 | 1 |
| 1 | 1100 | 1 | 0 |
| 1 | 0110 | f | not (f) |
| 1 | 1001 | not(f) | f |

Abgesehen von dem Precharge-Zustand dürfen also nur die vier oben genannten Werte von s angenommen werden. Dies kann jedoch durch eine Schaltung außerhalb des beschriebenen Datenpfades sichergestellt werden.

Die Signalverarbeitungsvorrichtung 12 kann beliebige Funktionen realisieren. Der einfachste Fall wäre: f(a) = a und fq(a) = aq. Je nachdem, ob die empfangenen Daten verschlüsselt sind oder nicht oder ob sonstige Funktionen realisiert werden sollen, kann in die Signalverarbeitungsvorrichtung 12 jede beliebige Schaltung eingesetzt werden. Zwei Beispiele sind in den Figuren 6 und 7 dargestellt. Die Schaltung in Figur 6 stellt dabei einen Multiplexer dar, während die Schaltung in Figur 7 ein XOR-Glied realisiert. Weitere Schaltungen sind dem Fachmann geläufig und können aus der Fachliteratur entnommen werden.

Durch die Schaltung von Figur 6 wird die Funktion

$$f\big(a\langle 3:1\rangle\big) = a\langle 1\rangle \cdot a\langle 2\rangle + \overline{a}\langle 1\rangle \cdot a\langle 3\rangle$$

durch die Funktionen

$$\hat{f} = a\langle 1\rangle \cdot a\langle 2\rangle + aq\langle 1\rangle \cdot a\langle 3\rangle$$

und

$$\hat{f}q = a\langle 1\rangle \cdot aq\langle 2\rangle + aq\langle 1\rangle \cdot aq\langle 3\rangle$$

realisiert.

Durch die Schaltung von Figur 7 wird die Funktion

$$f\left(a\langle 2:1\rangle\right) = a\langle 1\rangle \oplus a\langle 2\rangle$$

.

durch die Funktionen

$$\hat{f} = a\langle 1\rangle \cdot aq\langle 2\rangle + aq\langle 1\rangle \cdot a\langle 2\rangle$$

und

$$\hat{f}q = a\langle 1\rangle \cdot a\langle 2\rangle + aq\langle 1\rangle \cdot aq\langle 2\rangle$$

realisiert.

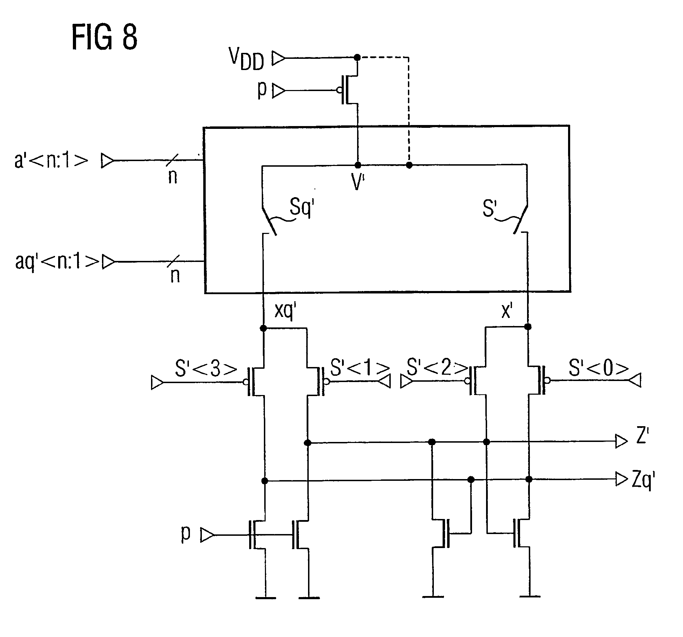

Die Figur 8 zeigt eine Abwandlung der Schaltungsanordnung aus Figur 4. Während die Schaltung in Figur 4 im wesentlichen aus n-Kanal-Transistoren aufgebaut ist, erfolgt der Aufbau bei einer Schaltungsanordnung nach Figur 8 hauptsächlich mit p-Kanal-Transistoren. Der sonstige Aufbau ist symmetrisch zum Aufbau der Schaltung aus Figur 4. Es ist darauf hinzuweisen, daß für die Precharge-Transistoren 25 jedoch n-Kanal-Transistoren verwendet werden, die mit dem Precharge-Signal p statt pq angesteuert sind. Der je nach Ansteuerung vorzusehende Fußpunkttransistor 16 ist ebenfalls mit dem Precharge-Signal p anzusteuern.

Bezugszeichenliste

| a, aq | Dateneingangssignal |
|-------|---------------------|
| z, zq | Datenausgangssignal |
| s, sq | Schalter(funktion) |
| p, pq | Vorladesignal |

| A1, A2 | Eingang der Schaltungsanordnung |
|--------|--------------------------------|
| F1, F2 | Ausgang der Schaltungsanordnung |
| D1, D2 | Eingang der Schaltvorrichtung |
| E1, E2 | Ausgang der Schaltvorrichtung |
| x, xq | Ausgang der Signalverarbeitungsvorrichtung |

| G | Steuereingang |
|---|---------------|
| V0 | erstes Potential |
| VDD | zweites Potential |

1 Eingangsschaltung
2 Rechenwerk
3 Datenverarbeitungsvorrichtung
4 Schaltungseinheit
5 AND-Glieder
6 OR-Glied
7 Steuersignal
11 Schaltungsanordnung
12 Signalverarbeitungsvorrichtung
13 Schaltvorrichtung
14 Potentialkontrollvorrichtung
15 Precharge-Transistoren
16 Fußpunkttransistor

**Patentansprüche**

1. Schaltungsanordnung zur Erzeugung eines Dual-Rail-Ausgangssignals (z, zq) mit

   - einem ersten Eingang mit mindestens zwei Anschlüssen (A1, A2) zum Empfang eines Dual-Rail-Eingangssignals (a, aq),
   - einem zweiten Eingang (G) zum Empfang eines Steuersignals (7),
   - einer Signalverarbeitungsvorrichtung (12) mit einem ersten (s) und einem zweiten (sq) jeweils in Anhängigkeit von dem Eingangssignal (a, aq) ansteuerbaren Schaltern sowie zwei Ausgängen (x, xq), wobei durch einen der Schalter (s, sq) der erste Ausgang (x) und durch den anderen Schalter (sq, s) der zweite Ausgang (xq) mit einem sich auf einem ersten Potential (0) befindlichen Fußpunkt (v) der Steuervorrichtung verbindbar sind,
   - einer Schaltvorrichtung (13), aufweisend einen ersten und einen zweiten Eingang (D1, D2), die mit den Ausgängen (x, xq) der Signalverarbeitungsvorrichtung verbunden sind, und einen ersten und einen zweiten Ausgang (E1, E2), die mit zwei Ausgängen (F1, F2) der Schaltungsanordnung zur Ausgabe eines Dual-Rail-Ausgangssignals (z, zq) verbunden sind, und
   - einer Potentialkontrollvorrichtung zur Festlegung der Potentiale der Ausgänge (F1, F2) der Schaltungsanordnung, wenn diese nicht über die Schaltvorrichtung (13) und die Signalverarbeitungsvorrichtung (12) mit dem Fußpunkt (v) der Signalverarbeitungsvorrichtung verbunden sind,

   **dadurch gekennzeichnet, dass** die Ausgänge (E1, E2) der Schaltvorrichtung in Abhängigkeit von einem Steuersignal (7) jeweils mit einem oder beiden Eingängen (D1, D2) verbindbar sind, wobei die Schaltvorrichtung derart ausgebildet ist, daß folgende Betriebssituationen ermöglicht sind:

   - der erste Ausgang (E1) verbunden mit dem ersten Eingang (D1) und der zweite Ausgang (E2) verbunden mit dem zweiten Eingang (D2)**:** z = not(f(a)),
   - der erste Ausgang (E1) verbunden mit dem zweiten Eingang (D2) und der zweite Ausgang (E2) verbunden mit dem ersten Eingang (D1) : z = f(a),
   - der erste Ausgang (E1) verbunden mit dem ersten Eingang (D1) und dem zweiten Eingang (D2), der zweite Ausgang (E2) offen: z = 0,
   - der zweite Ausgang (E2) verbunden mit dem ersten Eingang (D1) und dem zweiten Eingang (D2), der erste Ausgang (E1) offen: z = 1.

2. Schaltungsanordnung nach Anspruch 1,
   **dadurch gekennzeichnet, daß** eine durch ein Vorladesignal (pq; p) ansteuerbare Vorlade-Vorrichtung (15) vorgesehen ist, durch die vor jedem übertragenen Datum ein vorbestimmtes gleiches Potential an allen Daten führenden Anschlüsse (F1, F2) des Ausgangs erzeugbar ist.

3. Schaltungsanordnung nach einem der Ansprüche 1 oder 2,
   **dadurch gekennzeichnet, daß** in Reihe zu der Signalverarbeitungsvorrichtung (12) und der Schaltvorrichtung (13) ein durch das Vorladesignal (pq; p) ansteuerbarer Schalter angeordnet ist zur Verhinderung einer direkten Verbindung zwischen dem ersten Potential (V0) und dem zweiten Potential (VDD) über Schalter der Signalverarbeitungsvorrichtung (12) und der Schaltvorrichtung (13).

**4.** Schaltungsanordnung nach einem der Ansprüche 1 bis 3,
**dadurch gekennzeichnet, daß** die Signalverarbeitungsvorrichtung (12) ein Schaltnetz beinhaltet, durch das eine XOR-Funktion umsetzbar ist.

**5.** Verfahren zur Erzeugung eines Dual-Rail-Ausgangssignales z, zq auf zwei zusammengehörigen Datenleitungen mit den Verfahrensschritten:

- Bereitstellen eines durch ein Signal $\hat{f}$(a, aq) gesteuerten ersten Schalters (s) und eines durch ein zweites Signal $\hat{f}$q(a, aq) gesteuerten zweiten Schalters (sq) mit a, aq als Dual-Rail-Dateneingangssignal, wobei bei gültigem Datensignal mit aq = not(a) gilt, daß $\hat{f}$q(a) = not(f (a)) ist,
- Verbinden der Datenleitungen mit den Schaltern (s, sq) in folgenden Kombinationen:

- erste Datenleitung mit dem ersten Schalter (s) und zweite Datenleitung mit dem zweiten Schalter (sq) zur Ermöglichung der Funktion z = not(f(a)) oder
- erste Datenleitung mit dem zweiten Schalter (sq) und zweite Datenleitung mit dem ersten Schalter (s) zur Ermöglichung der Funktion z = f(a) oder
- erste Datenleitung mit dem ersten und dem zweiten Schalter (s, sq) und zweite Datenleitung weder mit dem ersten Schalter (s) noch mit dem zweiten Schalter (sq) zur Ermöglichung der Funktion z = 0 oder
- zweite Datenleitung mit dem ersten Schalter (s) und dem zweiten Schalter (sq) und erste Datenleitung weder mit dem ersten Schalter (s) noch mit dem zweiten Schalter (sq) zur Ermöglichung der Funktion z = 1,

wobei bei geschlossenem Schalter (s, sq) eine mit diesem verbundene Datenleitung auf ein ersten Potential gezogen wird und wobei der anderen Datenleitung ein zweites Potential zuordenbar ist.

**Claims**

**1.** Circuit arrangement for producing a dual-rail output signal (z, zq) having

- a first input with at least two connections (A1, A2) for receiving a dual-rail input signal (a, aq),
- a second input (G) for receiving a control signal (7),
- a signal processing apparatus (12) with a first switch (s) and a second switch (sq), which can each be driven as a function of the input signal (a, aq), and with two outputs (x, xq), in which case the first output (x) can be connected by means of one of the switches (s, sq) to a foot point (v), which is at a first potential (V0), of the control apparatus, and the second output (xq) can be connected by means of the other switch (sq, s) to said foot point (v) of the control apparatus,
- a switching apparatus (13), having a first input and a second input and a second input (D1, D2) which are connected to the outputs (x, xq) of the signal processing apparatus, and a first output and a second output and a second output (E1, E2) which are connected to two outputs (F1, F2) of the circuit arrangement in order to output the dual-rail output signal (z, zq), and
- a potential monitoring apparatus for defining the potentials at the outputs (F1, F2) of the circuit arrangement when these are not connected via the switching apparatus (13) and the signal processing apparatus (12) to the foot point (v) of the signal processing apparatus,

**characterized in that** the outputs (E1, E2) of the switching apparatus can each be connected to one or both of the inputs (D1, D2) as a function of a control signal (7), wherein the switching apparatus is designed to allow) the following operating situations:

- the first output (E1) connected to the first input (D1) and the second output (E2) connected to the second input (D2):
z = not(f(a)),
- the first output (E1) connected to the second input (D2) and the second output (E2) connected to the first input (D1) : z = f(a),
- the first output (E1) connected to the first input (D1) and the second input (D2), the second output (E2) open: z = 0,
- the second output (E2) connected to the first input (D1) and the second input (D2), the first output (E1) open: z = 1.

**2.** Circuit arrangement according to Claim 1,
**characterized in that** a precharge apparatus (15) is provided, which can be driven by a precharge signal (pq; p) and which can produce a predetermined identical potential, before each transmitted data item, at all the connections (F1, F2) of the output which carry data.

**3.** Circuit arrangement according to one of Claims 1 or 2,
**characterized in that** a switch which can be driven by the precharge signal (pq; p) is arranged in series with the signal processing apparatus (12) and the switching apparatus (13), in order to prevent a direct connection between the first potential (V0) and a second potential (VDD) via switches of the signal processing apparatus (12) and of the switching apparatus (13).

**4.** Circuit arrangement according to one of Claims 1 to 3,
**characterized in that** the signal processing apparatus (12) contains a switching network by means of which an XOR function can be implemented.

**5.** Method for producing a dual-rail output signal (z, zq) on two associated data lines, comprising the following method steps:

- provision of a first switch $(s)_\wedge$ which is controlled by a signal $\hat{f}$(a, aq), and of a second switch $(\hat{s}q)$, which is controlled by a second signal fq(a, aq), where a, aq is a dual-rail data input signal, in which case fq(a) = not (f (a)) for a valid data input signal for which aq = not (a),
- connection of the data lines to the switches (s, sq) in the following combinations:

   - first data line to the first switch (s) and second data line to the second switch (sq) to allow the function z =not (f(a)), or
   - first data line to the second switch (sq) and second data line to the first switch (s) to allow the function z =f(a), or
   - first data line to the first and to the second switch (s, sq) and second data line neither to the first switch (s) nor to the second switch (sq)to allow the function z=0, or
   - second data line to the first switch (s) and the second switch (sq), and first data line neither to the first switch (s) nor to the second switch (sq) to allow th function z = 1,

in which case, when a switch (s, sq) is closed, a data line which is connected to this switch (s, sq) is drawn to a first potential, and a second potential can be associated with the other data line.

**Revendications**

**1.** Circuit de production d'un signal (z, zq) de sortie double voie comprenant

   - une première entrée ayant au moins deux bornes (A1, A2) de réception d'un signal (a, aq) d'entrée double voie ;
   - une deuxième entrée (G) de réception d'un signal (7) de commande ;
   - un dispositif (12) de traitement du signal ayant un premier (s) et un deuxième (sq) interrupteurs pouvant être commandés, respectivement, en fonction du signal (a, aq) d'entrée, ainsi que deux sorties (x, xq), la première sortie (x) pouvant par l'un des interrupteurs (s, sq) et la deuxième sortie (xq) par l'autre interrupteur (sq, s) être reliées à un pied (v) du dispositif de commande se trouvant à un premier potentiel (V0) ;
   - un dispositif (13) de commutation ayant une première et une deuxième entrées (D1, D2) qui sont reliées aux sorties (x, xq) du dispositif de traitement du signal et une première et une deuxième sorties (E1, E2) qui sont reliées à deux sorties (F1, F2) du dispositif de commutation pour l'émission du signal (z, zq) de sortie double voie ; et
   - un dispositif de contrôle de potentiel pour fixer les potentiels des sorties (F1, F2) du dispositif de commutation lorsque celles-ci ne sont pas reliées par le dispositif (13) de commutation et le dispositif (12) de traitement du signal au pied (v) du dispositif de traitement du signal,

**caractérisé en ce que** les sorties (E1, E2) du dispositif de commutation peuvent être reliées en fonction d'un signal (7) de commande, respectivement, à l'une ou aux deux entrées (D1, D2), le dispositif de commutation étant tel que des situations suivantes de fonctionnement sont possibles :

   - la première sortie (E1) est reliée à la première entrée (D1) et la deuxième sortie (E2) est reliée à la deuxième entrée (D2) : z=not (f(a)),

- la première sortie (E1) est reliée à la deuxième entrée (D2) et la deuxième sortie (E2) est reliée à la première entrée (D1) : z = f(a),
- la première sortie (E1) est reliée à la première entrée (D1) et à la deuxième entrée (D2), la deuxième sortie (E2) est ouverte : z = 0,
- la deuxième sortie (E2) est reliée à la première entrée (D1) et à la deuxième entrée (D2), la première sortie (E1) est ouverte : z = 1.

2. Circuit suivant la revendication 1,
**caractérisé en ce qu'**il est prévu un dispositif (15) de précharge qui peut être commandé par un signal (pq, p) de précharge et par lequel, avant chaque donnée transmise, un potentiel identique déterminé à l'avance peut être produit sur toutes les bornes (F1, F2) de la sortie conduisant des données.

3. Circuit suivant l'une des revendications 1 ou 2,
**caractérisé en ce qu'**il est monté en série avec le dispositif (12) de traitement du signal et le dispositif (13) de commutation un interrupteur qui peut être commandé par le signal (pq, p) de précharge pour empêcher une liaison directe entre le premier potentiel (V0) et un deuxième potentiel (VDD) par des interrupteurs du dispositif (12) de traitement du signal et du dispositif (13) de commutation.

4. Circuit suivant l'une des revendications 1 à 3,
**caractérisé en ce que** le dispositif (12) de traitement du signal comporte un réseau de commutation par lequel une fonction OU exclusive peut être mise en oeuvre.

5. Procédé de production d'un signal (z, zq) de sortie double voie sur deux lignes de données associées comprenant les stades de procédé dans lequel :

- on met à disposition un premier interrupteur (s) commandé par un signal $\hat{f}$ (a, aq) et un deuxième interrupteur (sq) commandé par un deuxième signal $\hat{fq}$(a, aq), a, aq servant de signal d'entrée de données double voie dans lequel on a pour un signal de données valable avec aq = not(a), fq(a)= not(f(a)) ;
- on relie les lignes de données aux interrupteurs (s, sq) dans les combinaisons suivantes :

  - première de ligne de données au premier interrupteur (s) et deuxième ligne de données au deuxième interrupteur (sq) pour rendre possible la fonction z = not(f(a)) ou
  - première de ligne de données avec le deuxième interrupteur (sq) et deuxième ligne de données avec le premier interrupteur (s) pour permettre la fonction z = f(a) ou
  - première de ligne de données avec le premier et le deuxième interrupteurs (s, sq) et deuxième ligne de données ni avec le premier interrupteur (s) ni avec le deuxième interrupteur (sq) pour permettre la fonction z = 0 ou
  - deuxième de ligne de données avec le premier interrupteur (s) et avec le deuxième interrupteur (sq) et première ligne de données ni avec le premier interrupteur (s) ni avec le deuxième interrupteur (sq) pour permettre la fonction z = 1,

dans lequel, lorsque l'interrupteur (s, sq) est fermé, une ligne de données qui y est reliée est tirée à un premier potentiel et l'autre ligne de données peut être associée à un deuxième potentiel.

## FIG 1

## FIG 2

# FIG 3

## FIG 4

## FIG 5

# FIG 6

# FIG 7

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4570084 A